# EUROPEAN PATENT SPECIFICATION

(11) **EP 4 208 891 B1**
(45) Date of publication and mention of the grant of the patent: **18.03.2026**
(21) Application number: 21863594.4
(22) Date of filing: 31.08.2021
(51) Int. Cl.: H01L 23/13, H01L 23/15, H01L 21/48, G06K 19/077

(54) **IDENTIFICATION CARD AND MANUFACTURING METHOD OF IDENTIFICATION CARD**
IDENTIFIKATIONSKARTE UND HERSTELLUNGSVERFAHREN FÜR EINE IDENTIFIKATIONSKARTE
CARTE D'IDENTIFICATION ET PROCÉDÉ DE FABRICATION DE CARTE D'IDENTIFICATION

(30) Priority: 03.09.2020 CN 202010912457
(43) Date of publication of application: 12.07.2023
(73) Proprietor: Giesecke+Devrient ePayments GmbH, 81677 München (DE)
(72) Inventor: ZHU, Shunlong, Shanghai 200433 (CN); GU, Yunpeng, Shanghai 200433 (CN); CHEN, Wulin, Hubei 435000 (CN); QIU, Bingbo, Hubei 435000 (CN)
(74) Representative: Giesecke+Devrient IP
(86) International application number: PCT/CN2021/115588
(87) International publication number: WO 2022/048530

(56) References cited:
- WO-A1-2016/145574
- AU-A1- 2020 213 417
- CN-A- 104 636 794
- CN-A- 108 002 831
- CN-A- 108 960 395
- CN-A- 109 447 207
- CN-A- 109 447 207
- CN-A- 111 816 618
- CN-B- 106 866 142
- US-A1- 2017 344 870

## Description

### TECHNICAL FIELD

The invention belongs to the technical field of electronic products and particularly relates to an identification card and a manufacturing method for the identification card.

### BACKGROUND

An identification card is a medium used to identify individuals and store individual information. Various identification cards, such as work permits, ID cards, various financial transaction cards, membership cards, etc., have been widely used in people's lives. People have developed various anti-counterfeiting functions and/or decorations that provide special visual effects on various identification cards, for example, various financial cards, and the identification card in the prior art is easily deformed and has low structural strength.

US 20170344870 A1 discloses a transaction card with a ceramic body with a pocket on its primary surface hosting a microchip flush with the surface and a laser marked feature applied to the secondary surface wherein the laser marked feature does not overlap with the microchip. The card body can be manufactured using zirconia powder. The ceramic body can be polished.

AU 2020213417 A1 discloses a transaction card with a monolithic ceramic card body having a pocket located on its main surface which hosts a chip module. The surface may be polished. Further pockets may be located on the surface.

While using ceramic material for cards provides an alternative to plastic cards, it is prone to abrasion and fingerprints.

WO 2016145574 A1 discloses a ceramic body like a mobile terminal made of zirconia dioxide whose surface is coated with an anti-fingerprint film.

CN 109447207 A discloses an identification card with a ceramic substrate having a recess that is filled with a resin material combined with at least one of an information storage medium, a security feature, and a decorative feature. The substrate is made of oxide, metal carbide, metal boride, metal nitride, or metal silicide.

There is a need for a new identification card with an enhanced bending and wear resistance and a manufacturing method of such identification card.

### SUMMARY

The embodiment of the present invention provides an identification card as disclosed in claim 1 and a manufacturing method of the identification card as disclosed in claim 10, which have high hardness, high density, and tight structure, and can further enhance anti-bending and abrasion resistance of the identification card and increase the service life of the identification card.

In one aspect, an embodiment of the present invention provides an identification card, including: a ceramic substrate which includes a main body and an anti-fingerprint film, wherein the main component used in manufacturing of of the main body is zirconia powder, the main body has opposite surfaces, the anti-fingerprint film is arranged on each of the surfaces, and an accommodating slots are provided on the ceramic substrate, which slots are located on opposite surfaces of the main body and penetrate the anti-fingerprint film on the surface, and each accommodating slot has a bottom surface and an opening opposite to the bottom surface; and an information identification part arranged in the accommodating slot, wherein the information identification part includes a chip part and an information marking part, orthographic projections of chip part and information marking part on the ceramic substrate do not overlap, and in the thickness direction of the identification card, the chip part has opposite lower and upper surfaces, and the lower surface faces the bottom surface of the accommodating slot for accommodating the chip part, and the upper surface does not protrude from the opening of the accommodating slot for accommodating the chip part.

According to an aspect of the present invention, the particle size of the zirconia powder is 20 nm-40 nm.

According to an aspect of the present invention, at least part of the anti-fingerprint film is covered with a pattern layer, and the pattern layer is formed by at least one of the following processes: ultraviolet color printing, laser inkjet printing, and porcelain offset printing.

According to an aspect of the present invention, the zirconia powder is yttrium stabilized zirconia.

According to an aspect of the present invention, the information identification part further includes fixing layers, the chip part and the information marking part are respectively fixed on different fixing layers, and the fixing layers are connected and in contact with the accommodating slot.

According to an aspect of the present invention, the main body includes a first ceramic substrate and a second ceramic substrate connected to each other, and the accommodating slots are provided on at least one of the first ceramic substrate and the second ceramic substrate.

According to an aspect of the present invention, a pre-laminated layer in contact with the chip part is provided between the first ceramic substrate and the second ceramic substrate, and the chip part is connected to an antenna part of the pre-laminated layer.

According to an aspect of the present invention, a groove matching the second ceramic substrate is provided on the surface of the first ceramic substrate opposite to the second ceramic substrate, so that the second ceramic substrate is arranged in the groove.

According to an aspect of the present invention, the information marking part includes at least one of a magnetic strip, a bank logo, a signature strip, and a card body pattern part, and the bank logo and the card body pattern part are provided in a three-dimensional metal form.

In another aspect, an embodiment of the present invention provides a method for manufacturing an identification card, which is applied to the identification card in any of the above embodiments, the method includes: manufacturing the ceramic substrate and processing the zirconia powder into the main body of the ceramic substrate, wherein an anti-fingerprint film is provided on the surface of the main body; forming accommodating slots, providing the accommodating slots which are located on at least one side surface of the main body and penetrate the anti-fingerprint film on the surface, herein, the accommodating slot has a bottom surface and an opening opposite to the bottom surface; fixing the information identification part, setting the information identification part in the accommodating slot, herein, the orthographic projections of the chip part and the information marking part of the information identification part on the ceramic substrate do not overlap, and in the thickness direction of the identification card, the chip part has a lower surface and an upper surface opposite to each other, the lower surface faces the bottom surface of the accommodating slot of the chip part and the upper surface does not protrude from the opening of the accommodating slot for accommodating the chip part.

According to an aspect of the present invention, the processing the zirconia powder into the main body of the ceramic substrate includes: sequentially dissolving an organic monomer and a crosslinking agent in distilled water, adding an appropriate amount of dispersant to manufacture a premixed liquid; adding zirconia powder into the premixed liquid to obtain a slurry; adding initiator and catalyst into the slurry to form a gel structure; and curing the gel structure by a steel mold and then sintering and forming it to form a ceramic substrate.

According to another aspect of the present invention, in the step of adding zirconia powder into the premixed liquid to obtain a slurry, the ratio of zirconia powder to premixed liquid is 3.8:1 to 6.5:1.

According to another aspect of the present invention, the zirconia powder includes zirconia, hafnium dioxide, yttrium oxide, silicon dioxide, and iron oxide mixed in a preset ratio.

According to another aspect of the present invention, after the step of curing the gel structure by a steel mold and then sintering and forming it to form a ceramic substrate, the ceramic substrate will be carburized.

Compared with the prior art, the identification card provided by the embodiment of the present invention includes a ceramic substrate and an information identification part, an anti-fingerprint film is provided on each surface of the main body of the ceramic substrate to avoid leaving fingerprints on the surface of the ceramic substrate during use and effecting aesthetics. An information identification part is provided in the accommodating slot of the ceramic substrate, and the orthographic projections of the chip part and the information marking part of the information identification part on the ceramic substrate do not overlap to avoid mutual interference. And in the thickness direction of the identification card, the upper surface of the chip part does not protrude from the opening of the accommodating slot of the chip part, that is, the chip part does not protrude from the surface of the ceramic substrate, so as to prevent the chip part from being worn and damaged. In addition, the ceramic substrate is formed of zirconia powder with high hardness, high density, and tight structure, which can further enhance the bending and wear resistance of the identification card, and increase the service life of the identification card.

### BRIEF DESCRIPTION OF THE DRAWINGS

In order to more clearly illustrate technical solutions of embodiments of the invention, the drawings needed to be used in the embodiments of the invention will be briefly introduced below, and for those skilled in the art, without any creative work, other drawings can be obtained from these drawings.
Fig. 1 illustrates a schematic structural diagram of an identification card provided by an embodiment of the present invention;
Fig. 2 illustrates a schematic structural diagram of an identification card provided by another embodiment of the present invention;
Fig. 3 illustrates a schematic structural diagram of a display panel provided by another embodiment of the present invention;
FIG. 4 illustrates a schematic structural diagram of a display panel provided by another embodiment of the present invention;
Fig. 5 illustrates a schematic structural diagram of a display panel provided by another embodiment of the present invention;
Fig. 6 illustrates a schematic structural diagram of a display panel provided by another embodiment of the present invention; and
Fig. 7 illustrates a flowchart of an identification card manufacturing method provided by an embodiment of the present invention.

In the drawings:
1-ceramic substrate; 11-first ceramic substrate; 12-second ceramic substrate; 2-chip part; 3-information marking part; 4-anti-fingerprint film; 5-pattern layer; 6-fixing layer; 7- pre-laminated layer; 8-antenna part.

### DETAILED DESCRIPTION

Features and exemplary embodiments of various aspects of the invention will be described in detail below. In the following detailed description, many specific details are proposed in order to provide a comprehensive understanding of the invention. However, it is obvious to those skilled in the art that the invention can be implemented without some of these specific details. The following description of the embodiments is only to provide a better understanding of the invention by showing examples of the invention.

It should be noted that in this article, relational terms such as "first" and "second", etc., are only used to distinguish one entity or operation from another entity or operation, but do not necessarily require or imply that there is any such actual relationship or sequence between these entities or operations. Moreover, the terms "include", "comprise" or any other variants thereof are intended to cover non-exclusive inclusion, so that a process, method, article or device including a series of elements not only includes those elements, but also includes other elements that are not explicitly listed, or also include elements inherent to this process, method, article or equipment. In the event that there are no more restrictions, the elements defined by the sentence "including..." do not exclude the existence of other identical elements in the process, method, article, or equipment that includes the elements.

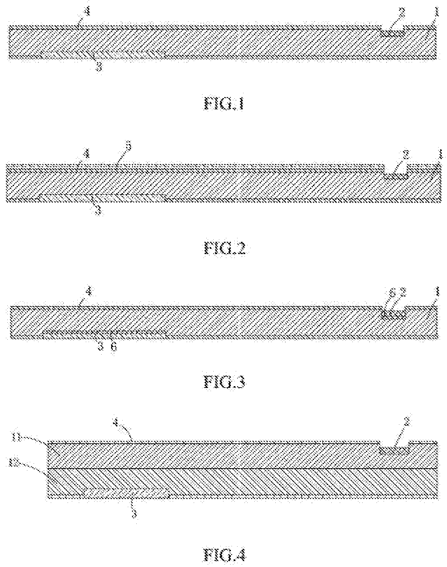

In order to better understand the invention, the identification card and the manufacturing method according to the embodiment of the invention will be described in detail below with reference to FIGS. 1 to 7.

Please refer to Fig. 1. Fig. 1 is a schematic structural diagram of an identification card provided by an embodiment of the present invention. An embodiment of the present invention provides an identification card, including: a ceramic substrate 1, which includes a main body and an anti-fingerprint film 4, herein a main component of the main body is zirconia powder, the main body has opposite surfaces, the anti-fingerprint film 4 is arranged on each surface, and an accommodating slot is provided on the ceramic substrate 1, which is located on at least one side surface of the main body and penetrates the anti-fingerprint film 4 on the surface, the accommodating slot has a bottom surface and an opening opposite to the bottom surface; and an information identification part arranged in the accommodating slot, herein, the information identification part includes a chip part 2 and an information marking part 3, the orthographic projections of the chip part 2 and the information marking part 3 on the ceramic substrate 1 do not overlap, and in the thickness direction of the identification card, the chip part 2 has opposite lower and upper surfaces, and the lower surface faces the bottom surface of the accommodating slot for accommodating the chip part 2, and the upper surface does not protrude from the opening of the accommodating slot for accommodating the chip part 2.

The identification card provided by the embodiment of the present invention includes a ceramic substrate 1 and an information identification part. An anti-fingerprint film 4 is provided on each surface of the main body of the ceramic substrate 1 to avoid leaving fingerprints on the surface of the ceramic substrate 1 during use and effecting aesthetics. An information identification part is provided in the accommodating slot of the ceramic substrate 1, the orthographic projections of the chip part 2 and the information marking part 3 of the information identification part on the ceramic substrate 1 do not overlap to avoid mutual interference, and in the thickness direction of the identification card, the upper surface of the chip part 2 does not protrude from the opening of the accommodating slot of the chip part 2, that is, the chip part 2 does not protrude from the surface of the ceramic substrate 1, so as to prevent the chip part 2 from being worn and damaged. In addition, the ceramic substrate 1 is formed of zirconia powder with high hardness, high density, and tight structure, which can further enhance the bending and wear resistance of the identification card, and increase the service life of the identification card.

It should be noted that the chip part 2 of the information identification part specifically implements functions such as identity recognition and mobile payment through the chip, and the information marking part 3 may specifically be a functional module for user identification, such as a magnetic strip, a signature strip, a bank logo, or an anti-counterfeiting label. The zirconia powder specifically includes components such as zirconia, hafnium dioxide, yttrium oxide, silicon dioxide and iron oxide mixed in a preset proportion, is formed by premixing, catalysis, curing, sintering, cutting and other processes, and the formed ceramic substrate 1 has higher mechanical properties and stronger toughness.

In some optional embodiments, the particle size of the zirconia powder is 20-40 nm. It is understandable that the selection of zirconia powder with a particle size of 20-40 nm can improve the smoothness of the formed ceramic substrate 1 and make the surface of the ceramic substrate 1 smoother.

Please refer to FIG. 2, in some optional embodiments, in order to display more information and improve the aesthetics of the identification card, at least part of the anti-fingerprint film 4 is covered with a pattern layer 5, and the pattern layer 5 is formed by at least one of the following processes: ultraviolet color printing, laser inkjet printing, and porcelain offset printing.

It should be noted that ultraviolet color printing, namely, UV (Ultra-Violet Ray) color printing process, must first ensure the cleanliness of the ceramic substrate 1, and coat the surface of the ceramic substrate 1 (increase the adhesion of the ink), select the high-definition picture on the computer, use the typesetting software to arrange the picture, fix the position of the ceramic substrate 1 on the printer, start the printer, and wait for the printing work to be completed. If one need to print the embossment effect, he/she needs to use a universal printer for white ink accumulation, and then use a UV printer to apply color ink; or combine with an engraving machine, first use the engraving machine to engrave the embossment effect on the surface of the ceramic substrate 1, and then use the UV printer for coloring processing.

In the laser inkjet printing process, the ceramic substrate 1 needs to be cleaned, and the surface of the ceramic substrate 1 needs to be coated (coating materials are varnish, diluent, and curing agent prepared in a certain proportion), and the surface of the ceramic substrate 1 is printed at a certain temperature, and after the printing is completed, it is allowed to stand for a period of time (the ambient temperature at the time determines the standing time) and then is baked at a low temperature.

In the ceramic offset printing process, it is also necessary to ensure that the ceramic substrate 1 is clean, the surface of the ceramic substrate 1 is coated, and the printing consumables are processed (selection and allocation of ink, preparation of fountain solution), and printing is performed, and it is dried at a room temperature.

Optionally, the zirconia powder is yttrium stabilized zirconia. It should be noted that there are three crystal forms of zirconia at room temperature, monoclinic, tetragonal and cubic. In order to stabilize zirconia in the cubic crystal form and increase heat resistance, some stabilizers need to be added. Yttrium stabilized zirconia specifically refers to zirconia with yttrium oxide as a stabilizer.

Please refer to FIG. 3, in order to improve the stability of the chip part 2 and the information marking part 3 when being fixed, in some optional embodiments, the information identification part further includes fixing layers 6, herein the chip part 2 and the information marking part 3 are respectively fixed on different fixing layers 6, and the fixing layers 6 are connected and in contact with the accommodating slot.

It should be noted that the fixing layer 6 may be specifically formed of one or a mixture of PVC (Polyvinyl chloride), PET (Polyethylene terephthalate), and ABS (Styrene resin, styrene resin), and other resin materials may also be used. The fixing layer 6 is a sheet structure for carrying the chip part 2 and the information marking part 3, and the fixing layer 6 and the chip part 2 or the information marking part 3 can be formed into a one-piece structure by stamping and other processes. Specifically, a plurality of information marking parts 3 may be uniformly arranged on the large fixing layer 6 at first, and a one-piece structure including the large fixing layer 6 and a plurality of information marking parts 3 may be formed by stamping and other processes, and afterwards, a one-piece structure including only the single information marking part 3 is formed by stamping, cutting, and other processes to improve production efficiency. Afterwards, the formed one-piece structure is connected to the accommodating part by means of adhesive bonding or the like. The connection of the chip part 2 and the fixing layer 6 is the same as the processing method of the information marking part 3 and the fixing layer 6 described above.

Please refer to FIG. 4, in some alternative embodiments, the main body includes a first ceramic substrate 1 and a second ceramic substrate 12 connected to each other, and the accommodating slot is provided on at least one of the first ceramic substrate 1 and the second ceramic substrate 12.

It can be understood that the first ceramic substrate 1 and the second ceramic substrate 12 are connected and fitted to each other to form a ceramic substrate 1, and the accommodating slot is located on the opposite surface of the first ceramic substrate 1 or the second ceramic substrate 12, that is, the accommodating slot may be a closed space, the first ceramic substrate 1 and the second ceramic substrate 12 are used to fix the marking joint part between them, and the first ceramic substrate 1 or the second ceramic substrate 12 may also be opened to form a through hole, so as to expose the marking part in the marking joint part for easy identification.

In addition to split structure of the above-mentioned ceramic substrate 1 including the first ceramic substrate 1 and the second ceramic substrate 12, the ceramic substrate 1 may also be a one-piece structure, as shown in the figure, that is, the ceramic substrate 1 is an integrated sheet-like structure, and an accommodating slot is directly arranged on the outer surface of the ceramic substrate 1, and the marking joint part is connected to the ceramic substrate 1 by means of adhesive bonding or the like.

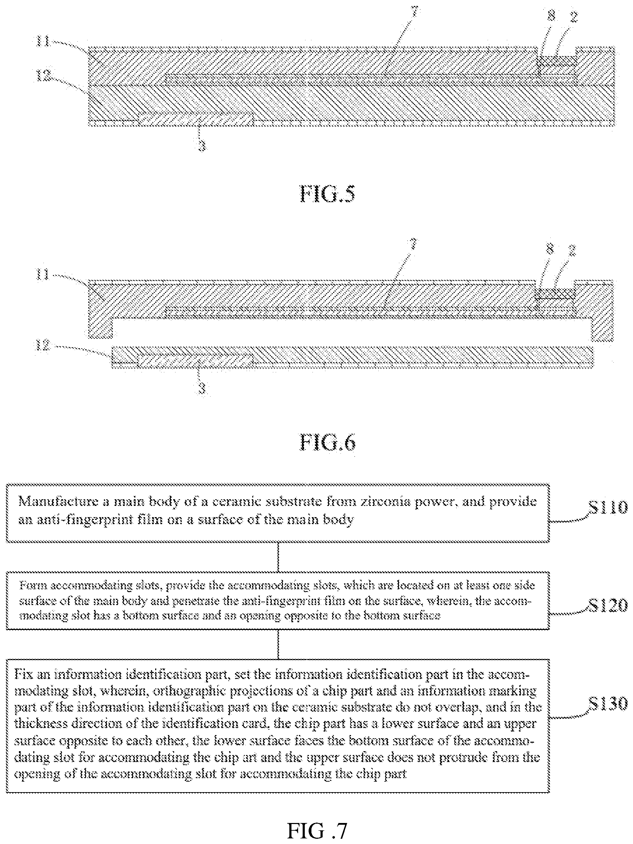

Please refer to FIG. 5, a pre-laminated layer 7 in contact with the chip part 2 is provided between the first ceramic substrate 11 and the second ceramic substrate 12, and the chip part 2 is connected to the antenna part 8 of the pre-laminated layer 7.

It should be noted that the pre-laminated layer 7 generally refers to the INLAY layer. Optionally, the pre-laminated layer 7 is a flexible material layer, specifically refers to a pre-laminated product composed of a multilayer PVC sheet containing antennas or coils together. Generally, it consists of two or three layers. Without any printed patterns on the surface, INLAY products are suitable for the early mass production of various types of cards. The INLAY is covered with materials with different printing patterns on the top and the bottom to form different non-contact cards by laminating them again. PCB (Printed Circuit Board), FPC (Flexible Printed Circuit) can also be used, similar to the NFC antenna (Near Field Communication) used in mobile phones.

Please refer to FIG. 6, in some optional embodiments, a groove matching the second ceramic substrate 12 is provided on the surface of the first ceramic substrate 11 opposite to the second ceramic substrate 12, so that the second ceramic substrate 12 is arranged in the groove.

The opposite surfaces of the first ceramic substrate 11 and the second ceramic substrate 12 are provided with grooves matching the second ceramic substrate 12, that is, the shapes and sizes of the first ceramic substrate 11 and the second ceramic substrate 12 are inconsistent, the size of the first ceramic substrate 11 is larger than the size of the second ceramic substrate 12, so that the second ceramic substrate 12 can be accommodated by the groove, specifically, in the form of clamping. And because the second ceramic substrate 12 is arranged in the groove, the possibility of separation of the first ceramic substrate 11 and the second ceramic substrate 12 can be effectively reduced, and the connection stability of the identification card can be further improved.

In some optional embodiments, the chip part 2 and the information marking part 3 are respectively provided in the accommodating slot on the opposite surfaces of the first ceramic substrate 11 and the second ceramic substrate 12.

It should be noted that the accommodating slot is not limited to only being provided on one of the first ceramic substrate 11 or the second ceramic substrate 12. It may be provided on the first ceramic substrate 11 and the second ceramic substrate 12, that is, the accommodating slot includes a first accommodating slot and a second accommodating slot, the chip part 2 and the information marking part 3 are respectively fixed in the first accommodating slot and the second accommodating slot, and the chip part 2 can specifically include components such as carrier tapes and chips.

In some optional embodiments, the information marking part 3 includes at least one of a magnetic strip, a bank logo, a signature strip, and a card body pattern part, and the bank logo and the card body pattern part are provided in a three-dimensional metal form.

It should be noted that the three-dimensional metal form specifically refers to a three-dimensional metal pattern process, that is, the bank logo, card body pattern part, etc., can protrude from the outer surface of the ceramic substrate 1 to present a three-dimensional effect and improve the level and effect of identification card layout design.

Referring to FIG. 7, an embodiment of the present invention also provides a method for manufacturing an identification card, which is applied to the identification card in any of the above embodiments, the method includes:
S110: manufacturing main body of the ceramic substrate 1 from zirconia powder, and providing anti-fingerprint film 4 on the surface of the main body;
S120: forming accommodating slots, providing the accommodating slots, which are located on at least one side surface of the main body and penetrate the anti-fingerprint film 4 on the surface, herein, the accommodating slot has a bottom surface and an opening opposite to the bottom surface; and
S130: fixing an information identification part, and setting the information identification part in the accommodating slot, herein, the orthographic projections of the chip part 2 and the information marking part 3 of the information identification part on the ceramic substrate 1 do not overlap, and in the thickness direction of the identification card, the chip part 2 has a lower surface and an upper surface opposite to each other, the lower surface faces the bottom surface of the accommodating slot of the chip part 2 and the upper surface does not protrude from the opening of the accommodating slot for accommodating the chip part 2.

In step S110, an anti-fingerprint film 4 is provided on the surface of the main body of the ceramic substrate 1. The anti-fingerprint film 4 is obtained by performing AF (Anti-Fingerprint, anti-fingerprint film 4) processing on the surface of the ceramic substrate 1, and its functions include anti-fingerprint, anti-scratch, increasing abrasion resistance and feel.

In step S120, the forming of accommodating slot may be formed by numerical control machine tool such as numerical control milling machine or numerical control drilling machine. Specifically, the ceramic substrate 1 manufactured from zirconia powder is first cut to a certain shape by the numerical control milling machine and then further trimmed; the trimmed ceramic is drilled with holes in a certain size by the numerical control drilling machine; the drilled ceramics are sequentially rough polished and fine polished by polishing equipment; the polished ceramic surfaces are coated with a film layer by the screen printing machine; and the coated ceramic surfaces are processed with the anti-fingerprint film 4.

The identification card manufacturing method provided by the embodiment of the present invention manufactures the ceramic substrate 1 from zirconia powder, which has high structural strength and is not easily deformed. An anti-fingerprint film 4 is provided on each surface of the ceramic substrate 1 to avoid leaving fingerprints on the surface of the ceramic substrate 1 during use.

In some optional embodiments, manufacturing the ceramic substrate 1 from zirconia powder includes: sequentially dissolving an organic monomer and a crosslinking agent in distilled water, adding an appropriate amount of dispersant to manufacture a premixed liquid; adding zirconia powder into the premixed liquid to obtain a slurry; adding initiator and catalyst into the slurry to form a gel structure; and curing the gel structure by a steel mold and then sintering and forming it to form a ceramic substrate 1.

It should be noted that the organic monomer may be acrylamide CH3CONH2, abbreviated as AM, and the crosslinking agent may be methylene bisacrylamide CTH10N2O2, abbreviated as MBAM; initiator: ammonium persulfate (NH4) 2S2O8, abbreviated as APS; and Catalyst: Tetramethylethylenediamine C6H16N2, abbreviated as TEMED.

Herein, the ratio of the distilled water to the organic monomer to the crosslinking agent to the dispersant is 43:9.5 ~ 10.3:0.5:6.8 ~ 8.1 (the actual amount of water added needs to be changed according to the quality of the zirconia powder used). In the step of adding zirconia powder into the premixed liquid to obtain a slurry: the ratio of the zirconia powder to the premixed liquid is 3.8:1 to 6.5:1, and the actual ratio needs to be determined based on the amount of distilled water in the premixed liquid used, and the distilled water is deionized water. The initiator and catalyst have an important influence on the curing time of the slurry gel. The curing time will decrease, and when the initiator is added in the range of 0.2 ~ 1.0%, the catalyst is added in the range of 0.5 ~ 1.0%, the decreasing range is 45 mins ~ 13 mins.

In some optional embodiments, the zirconia powder includes zirconia, hafnium dioxide, silicon dioxide, and iron oxide mixed in a preset ratio, and yttrium oxide can also be mixed. The specific ratio is shown in the following table 1. Table 1 is a mass percentage table of each component of zirconia powder.

**Table 1**

| component | zirconia | hafnium dioxide | silicon dioxide | iron oxide | others |
|---|---|---|---|---|---|
| Mass percentage (%) | 94.4~95 | 5~5.6 | 0~0.01 | 0~0.01 | 0~0.017 |

In an optional embodiment, the mass percentage of zirconia is 94.4%, the mass percentage of hafnium dioxide is 5.563%, the mass percentage of silicon dioxide is 0.01%, and the mass percentage of iron oxide is 0.01%, the mass percentages of others are 0.017%, and the others specifically may be some impurities. The ratio of distilled water to organic monomer to crosslinking agent to dispersant is 43:9.5:0.5:6.8, while the ratio of zirconia powder to premixed liquid is 3.8:1, and the amount of initiator added is 0.2%, the amount of catalyst added is 0.5%, and the condensed ceramics are cured at 60°C for 10 minutes and then are sintered and formed.

In another embodiment of the component of zirconia powder, the mass percentage of zirconia is 95%, the mass percentage of hafnium dioxide is 5%, the mass percentage of silicon dioxide is 0%, and the mass percentage of iron oxide is 0%, and the mass percentages of others are 0%. The ratio of distilled water to organic monomer to crosslinking agent to dispersant is 43:10.3:0.5:8.1, while the ratio of zirconia powder to premixed liquid is 6.5:1, the amount of initiator added is 1.0%, and the amount of catalyst added is 1.0%, the condensed ceramics are cured at 70°C for 20 minutes and then are sintered and formed.

Identification cards in different color need to be processed differently. For example, the formed ceramic substrate 1 needs to be carburized and blackened when manufacturing a black identification card by: placing the ceramic substrate 1 and black carbon powder in a vacuum furnace, starting heating after the vacuum pumping to a certain pressure, rising temperature at a certain rate, performing high-temperature carburizing at about 1500°C, and then cooling to room temperature with the furnace, ultrasonic cleaning in alcohol to remove the impurities adhering on the surface, and then baking to obtain black zirconia ceramic flakes. Optionally, the condensed ceramic substrate 1 is cured at 60°C to 70°C for 10 to 20 minutes and then is sintered and formed.

## Claims

1. An identification card, including:
a ceramic substrate (1) which includes a main body that has opposite surfaces, **characterized in that**
the main component used in manufacturing of the main body is zirconia powder,
the ceramic substrate (1) includes an anti-fingerprint film (4) arranged on each of the surfaces of the main body;
accommodating slots are provided on the ceramic substrate (1), which slots are located on opposite surfaces of the main body and penetrate the anti-fingerprint film (4) on the surfaces, and accommodating slots each have bottom surface and an opening opposite to the bottom surface; and
an information identification part arranged in the accommodating slots, wherein the information identification part includes a chip part (2) and an information marking part, orthographic projections of the chip part (2) and the information marking part (3) on the ceramic substrate (1) do not overlap, and in the thickness direction of the identification card, the chip part (2) has opposite lower and upper surfaces, and the lower surface faces the bottom surface of the accommodating slot for accommodating the chip part (2), and the upper surface does not protrude from the opening of the accommodating slot for accommodating the chip part.

2. The identification card according to claim 1, **characterized in that** a particle size of the zirconia powder is 20 nm-40 nm.

3. The identification card according to claim 2, **characterized in that** at least part of the anti-fingerprint film (4) is covered with a pattern layer, and the pattern layer is formed by at least one of the following processes: ultraviolet color printing, laser inkjet printing, and porcelain offset printing.

4. The identification card according to claim 1, **characterized in that** the zirconia powder is yttrium stabilized zirconia.

5. The identification card according to claim 1, **characterized in that** the information identification part further includes fixing layers (6), and the chip part (2) and the information marking part (3) are respectively fixed on different fixing layers (6), and the fixing layers (6) are connected and in contact with the accommodating slot.

6. The identification card according to claim 1, **characterized in that** the main body includes a first ceramic substrate (1) and a second ceramic substrate (1) connected to each other, and the accommodating slots are provided on at least one of the first ceramic substrate (1) and the second ceramic substrate.

7. The identification card according to claim 6, **characterized in that** a pre-laminated layer (7) in contact with the chip part (2) is provided between the first ceramic substrate (1) and the second ceramic substrate, and the chip part (2) is connected to an antenna part (8) of the pre-laminated layer (7).

8. The identification card according to claim 7, **characterized in that** a groove matching the second ceramic substrate (1)is provided on the surface of the first ceramic substrate (1)opposite to the second ceramic substrate, so that the second ceramic substrate (1)is arranged in the groove.

9. The identification card according to claim 1, **characterized in that** the information marking part (3) includes at least one of a magnetic strip, a bank logo, a signature strip, and a card body pattern part, and the bank logo and the card body pattern part are provided in a three-dimensional metal form.

10. A method for manufacturing an identification card according to claim 1, **characterized in that** the method includes:
manufacturing the ceramic substrate (1) and processing the zirconia powder into the main body of the ceramic substrate, wherein an anti-fingerprint film (4) is provided on the surface of the main body;
forming accommodating slots, wherein the accommodating slots are located on opposite side surface of the main body and penetrate the anti-fingerprint film (4) provided on the surface, wherein, the accommodating slot has a bottom surface and an opening opposite to the bottom surface; and
fixing an information identification part, and setting the information identification part in the accommodating slot, wherein, orthographic projections of the chip part (2) and the information marking part (3) of the information identification part on the ceramic substrate (1) do not overlap, and in the thickness direction of the identification card, the chip part (2) has a lower surface and an upper surface opposite to each other, the lower surface faces the bottom surface of the accommodating slot of the chip part (2), and the upper surface does not protrude from the opening of the accommodating slot for accommodating the chip part (2).

11. The manufacturing method of identification card according to claim 10, **characterized in that** processing the zirconia powder into the main body of the ceramic substrate (1) includes:
sequentially dissolving an organic monomer and a crosslinking agent in distilled water, and adding an appropriate amount of dispersant to manufacture a premixed liquid;
adding zirconia powder into the premixed liquid to obtain a slurry;
adding initiator and catalyst into the slurry to form a gel structure; and
curing the gel structure by a steel mold and then sintering and forming it to form a ceramic substrate.

12. The manufacturing method of identification card according to claim 11, **characterized in that** in the step of adding zirconia powder into the premixed liquid to obtain a slurry, the ratio of zirconia powder to premixed liquid is 3.8:1 to 6.5:1.

13. The manufacturing method of identification card according to claim 10, **characterized in that** the zirconia powder includes zirconia, hafnium dioxide, yttrium oxide, silicon dioxide, and iron oxide mixed in a preset ratio.

14. The manufacturing method of identification card according to claim 11, **characterized in that** after the step of curing the gel structure by a steel mold and then sintering and forming it to form a ceramic substrate, the method further includes: carburizing the ceramic substrate.

## Patentansprüche

1. Identifikationskarte, umfassend:
ein Keramiksubstrat (1), das einen Hauptkörper mit gegenüberliegenden Oberflächen umfasst, **dadurch gekennzeichnet, dass**
der Hauptbestandteil, der bei der Herstellung des Hauptkörpers verwendet wird, Zirkonoxidpulver ist,
das Keramiksubstrat (1) eine Anti-Fingerabdruck-Folie (4) umfasst, die auf jeder der Oberflächen des Hauptkörpers angeordnet ist;
Aufnahmeschlitze auf dem Keramiksubstrat (1) vorgesehen sind, die sich auf gegenüberliegenden Oberflächen des Hauptkörpers befinden und die Anti-Fingerabdruck-Beschichtung (4) auf den Oberflächen durchdringen, und die Aufnahmeschlitze jeweils eine Bodenfläche und eine der Bodenfläche gegenüberliegende Öffnung aufweisen; und
ein Informationsidentifizierungsteil in den Aufnahmeschlitzen angeordnet ist, wobei das Informationsidentifizierungsteil ein Chipteil (2) und ein Informationsmarkierungsteil umfasst, orthogonale Projektionen des Chipteils (2) und des Informationsmarkierungsteils (3) auf dem Keramiksubstrat (1) sich nicht überlappen und in der Dickenrichtung der Identifizierungskarte der Chipteil (2) eine gegenüberliegende untere und obere Fläche aufweist, wobei die untere Fläche der Bodenfläche des Aufnahmeschlitzes zum Aufnehmen des Chipteils (2) zugewandt ist und die obere Fläche nicht aus der Öffnung des Aufnahmeschlitzes zum Aufnehmen des Chipteils herausragt.

2. Identifikationskarte nach Anspruch 1, **dadurch gekennzeichnet, dass** die Partikelgröße des Zirkonoxidpulvers 20 nm bis 40 nm beträgt.

3. Identifikationskarte nach Anspruch 2, **dadurch gekennzeichnet, dass** mindestens ein Teil der Anti-Fingerabdruck-Folie (4) mit einer Musterschicht bedeckt ist und die Musterschicht durch mindestens eines der folgenden Verfahren gebildet wird: Ultraviolett-Farbdruck, Laser-Tintenstrahldruck und Porzellan-Offsetdruck.

4. Identifikationskarte nach Anspruch 1, **dadurch gekennzeichnet, dass** das Zirkoniumoxidpulver yttriumstabilisiertes Zirkoniumoxid ist.

5. Identifikationskarte nach Anspruch 1, **dadurch gekennzeichnet, dass** der Informationsidentifikationsteil ferner Fixierschichten (6) umfasst und der Chipteil (2) und der Informations smarkierungsteil (3) jeweils auf unterschiedlichen Fixierschichten (6) fixiert sind und die Fixierschichten (6) mit dem Aufnahmeschlitz verbunden sind und diesen berühren.

6. Identifikationskarte nach Anspruch 1, **dadurch gekennzeichnet, dass** der Hauptkörper ein erstes Keramiksubstrat (1) und ein zweites Keramiksubstrat (1) umfasst, die miteinander verbunden sind, und dass die Aufnahmeschlitze auf mindestens einem der ersten Keramiksubstrate (1) und den zweiten Keramiksubstraten vorgesehen sind.

7. Identifikationskarte nach Anspruch 6, **dadurch gekennzeichnet, dass** eine mit dem Chipteil (2) in Kontakt stehende vorlaminierte Schicht (7) zwischen dem ersten Keramiksubstrat (1) und dem zweiten Keramiksubstrat vorgesehen ist und der Chipteil (2) mit einem Antennenteil (8) der vorlaminierten Schicht (7) verbunden ist.

8. Identifikationskarte nach Anspruch 7, **dadurch gekennzeichnet, dass** eine zum zweiten Keramiksubstrat (1) passende Nut auf der dem zweiten Keramiksubstrat gegenüberliegenden Oberfläche des ersten Keramiksubstrats (1) vorgesehen ist, so dass das zweite Keramiksubstrat (1) in der Nut angeordnet ist.

9. Identifikationskarte nach Anspruch 1, **dadurch gekennzeichnet, dass** der Informationsmarkierungsteil (3) mindestens eines von einem Magnetstreifen, einem Banklogo, einem Unterschriftsstreifen und einem Kartenkörpermusterteil umfasst und das Banklogo und der Kartenkörpermusterteil in einer dreidimensionalen Metallform vorgesehen sind.

10. Verfahren zur Herstellung einer Identifikationskarte gemäß Anspruch 1, **dadurch gekennzeichnet, dass** das Verfahren umfasst:
Herstellen des Keramiksubstrats (1) und Verarbeiten des Zirkoniumoxidpulvers zum Hauptkörper des Keramiksubstrats, wobei eine Anti-Fingerabdruck-Folie (4) auf der Oberfläche des Hauptkörpers vorgesehen ist;
Ausbilden von Aufnahmeschlitzen, wobei sich die Aufnahmeschlitze auf gegenüberliegenden Seitenflächen des Hauptkörpers befinden und die auf der Oberfläche vorgesehene Anti-Fingerabdruck-Beschichtung (4) durchdringen, wobei der Aufnahmeschlitz eine Bodenfläche und eine der Bodenfläche gegenüberliegende Öffnung aufweist; und
Befestigen eines Informationsidentifizierungsteils und Einsetzen des Informationsidentifizierungsteils in den Aufnahmeschlitz, wobei sich die orthogonalen Projektionen des Chipteils (2) und des Informationsmarkierungsteils (3) des Informationsidentifizierungsteils auf dem Keramiksubstrat (1) nicht überlappen, und in der Dickenrichtung der Identifikationskarte der Chipteil (2) eine Unterseite und eine Oberseite aufweist, die einander gegenüberliegen, wobei die Unterseite der Unterseite des Aufnahmeschlitzes des Chipteils (2) zugewandt ist und die Oberseite nicht aus der Öffnung des Aufnahmeschlitzes zum Aufnehmen des Chipteils (2) herausragt.

11. Verfahren zur Herstellung einer Identifikationskarte gemäß Anspruch 10, **dadurch gekennzeichnet, dass** die Verarbeitung des Zirkoniumoxidpulvers zum Hauptkörper des Keramiksubstrats (1) umfasst:
das aufeinanderfolgende Auflösen eines organischen Monomers und eines Vernetzungsmittels in destilliertem Wasser und das Hinzufügen einer geeigneten Menge eines Dispergiermittels, um eine vorgemischte Flüssigkeit herzustellen;
Zusetzen von Zirkoniumoxidpulver zu der vorgemischten Flüssigkeit, um eine Aufschlämmung zu erhalten;
Hinzufügen eines Initiators und eines Katalysators zu der Aufschlämmung, um eine Gelstruktur zu bilden; und
Aushärten der Gelstruktur in einer Stahlform und anschließendes Sintern und Formen, um ein Keramiksubstrat zu bilden.

12. Verfahren zur Herstellung einer Identifikationskarte gemäß Anspruch 11, **dadurch gekennzeichnet, dass** in dem Schritt des Hinzufügens von Zirkoniumoxidpulver zu der vorgemischten Flüssigkeit, um eine Aufschlämmung zu erhalten, das Verhältnis von Zirkoniumoxidpulver zu vorgemischter Flüssigkeit 3,8:1 bis 6,5:1 beträgt.

13. Verfahren zur Herstellung einer Identifikationskarte gemäß Anspruch 10, **dadurch gekennzeichnet, dass** das Zirkoniumoxidpulver Zirkoniumoxid, Hafniumdioxid, Yttriumoxid, Siliziumdioxid und Eisenoxid in einem vorgegebenen Verhältnis gemischt enthält.

14. Verfahren zur Herstellung einer Identifikationskarte gemäß Anspruch 11, **dadurch gekennzeichnet, dass** nach dem Schritt des Aushärtens der Gelstruktur durch eine Stahlform und dem anschließenden Sintern und Formen zu einem Keramiksubstrat das Verfahren ferner umfasst: Aufkohlen des Keramiksubstrats.

## Revendications

1. Carte d'identification, comprenant :
un substrat en céramique (1) qui comprend un corps principal présentant des surfaces opposées, **caractérisée en ce que**
le composant principal utilisé dans la fabrication du corps principal est de la poudre de zircone,
le substrat céramique (1) comprend un film anti-traces de doigts (4) disposé sur chacune des surfaces du corps principal ;
des fentes de logement sont prévues sur le substrat céramique (1), lesquelles fentes sont situées sur les surfaces opposées du corps principal et pénètrent dans le film anti-traces de doigts (4) sur les surfaces, et les fentes de logement ont chacune une surface inférieure et une ouverture opposée à la surface inférieure ; et
une partie d'identification d'informations est disposée dans les fentes de logement, la partie d'identification d'informations comprenant une partie puce (2) et une partie de marquage d'informations, les projections orthographiques de la partie puce (2) et de la partie de marquage d'informations (3) sur le substrat en céramique (1) ne se chevauchent pas, et dans le sens de l'épaisseur de la carte d'identification, la partie puce (2) a des surfaces inférieure et supérieure opposées, et la surface inférieure fait face à la surface inférieure de la fente de logement pour loger la partie puce (2), et la surface supérieure ne dépasse pas de l'ouverture de la fente de logement pour loger la partie puce.

2. La carte d'identification selon la revendication 1, **caractérisée en ce que** la taille des particules de la poudre de zircone est comprise entre 20 nm et 40 nm.

3. La carte d'identification selon la revendication 2, **caractérisée en ce qu'**au moins une partie du film anti-empreintes digitales (4) est recouverte d'une couche à motifs, et la couche à motifs est formée par au moins l'un des procédés suivants : impression couleur ultraviolette, impression à jet d'encre laser et impression offset sur porcelaine.

4. Carte d'identification selon la revendication 1, **caractérisée en ce que** la poudre de zircone est de la zircone stabilisée à l'yttrium.

5. Carte d'identification selon la revendication 1, **caractérisée en ce que** la partie d'identification d'informations comprend en outre des couches de fixation (6), et la partie puce (2) et la partie de marquage d' s d'identification (3) sont respectivement fixées sur différentes couches de fixation (6), et les couches de fixation (6) sont reliées et en contact avec la fente de logement.

6. Carte d'identification selon la revendication 1, **caractérisée en ce que** le corps principal comprend un premier substrat céramique (1) et un deuxième substrat céramique (1) reliés l'un à l'autre, et les fentes de logement sont prévues sur au moins l'un des premier substrat céramique (1) et deuxième substrat céramique.

7. Carte d'identification selon la revendication 6, **caractérisée en ce qu'**une couche pré-laminée (7) en contact avec la partie puce (2) est prévue entre le premier substrat céramique (1) et le deuxième substrat céramique, et la partie puce (2) est connectée à une partie antenne (8) de la couche pré-laminée (7).

8. Carte d'identification selon la revendication 7, **caractérisée en ce qu'**une rainure correspondant au deuxième substrat céramique (1) est prévue sur la surface du premier substrat céramique (1) opposée au deuxième substrat céramique, de sorte que le deuxième substrat céramique (1) est disposé dans la rainure.

9. Carte d'identification selon la revendication 1, **caractérisée en ce que** la partie de marquage d'informations (3) comprend au moins l'un parmi une bande magnétique, un logo bancaire, une bande de signature et une partie de motif du corps de la carte, et le logo bancaire et la partie de motif du corps de la carte sont prévus sous une forme métallique tridimensionnelle.

10. Procédé pour fabriquer une carte d'identification selon la revendication 1, **caractérisé en ce que** le procédé comprend :
la fabrication du substrat céramique (1) et le traitement de la poudre de zircone dans le corps principal du substrat céramique, dans lequel un film anti-empreintes digitales (4) est prévu sur la surface du corps principal ;
la formation de fentes de logement, dans lequel les fentes de logement sont situées sur la surface latérale opposée du corps principal et pénètrent dans le film anti-traces de doigts (4) prévu sur la surface, dans lequel la fente de logement a une surface inférieure et une ouverture opposée à la surface inférieure ; et
fixer une partie d'identification d'informations et placer la partie d'identification d'informations dans la fente de logement, dans laquelle les projections orthographiques de la partie puce (2) et de la partie de marquage d'informations (3) de la partie d'identification d'informations sur l' de substrat céramique (1) ne se chevauchent pas, et dans le sens de l'épaisseur de la carte d'identification, la partie puce (2) comporte une surface inférieure et une surface supérieure opposées l'une à l'autre, la surface inférieure fait face à la surface inférieure de la fente de logement de la partie puce (2), et la surface supérieure ne dépasse pas de l'ouverture de la fente de logement destinée à loger la partie puce (2).

11. Procédé de fabrication d'une carte d'identification selon la revendication 10, **caractérisé en ce que** le traitement de la poudre de zircone dans le corps principal du substrat céramique (1) comprend :
la dissolution séquentielle d'un monomère organique et d'un agent de réticulation dans de l'eau distillée, et l'ajout d'une quantité appropriée de dispersant pour fabriquer un liquide prémélangé ;
ajouter de la poudre de zircone dans le liquide prémélangé pour obtenir une bouillie ;
ajouter un initiateur et un catalyseur dans la bouillie pour former une structure de gel ; et
durcir la structure de gel à l'aide d'un moule en acier, puis la fritter et la former pour obtenir un substrat céramique.

12. Procédé de fabrication d'une carte d'identification selon la revendication 11, **caractérisé en ce que**, dans l'étape consistant à ajouter de la poudre de zircone dans le liquide prémélangé pour obtenir une bouillie, le rapport entre la poudre de zircone et le liquide prémélangé est compris entre 3,8:1 et 6,5:1.

13. Procédé de fabrication d'une carte d'identification selon la revendication 10, **caractérisé en ce que** la poudre de zircone comprend de la zircone, du dioxyde d'hafnium, de l'oxyde d'yttrium, du dioxyde de silicium et de l'oxyde de fer mélangés dans un rapport prédéfini.

14. Procédé de fabrication d'une carte d'identification selon la revendication 11, **caractérisé en ce qu'**après l'étape consistant à durcir la structure de gel à l'aide d'un moule en acier, puis à la fritter et à la former pour obtenir un substrat céramique, le procédé comprend en outre : la cémentation du substrat céramique.
